# EUROPÄISCHE PATENTSCHRIFT

(11) **EP 1 989 084 B1**
(45) Veröffentlichungstag und Bekanntmachung des Hinweises auf die Patenterteilung: **17.08.2011**
(21) Anmeldenummer: 07712230.7
(22) Anmeldetag: 16.02.2007
(51) Int. Cl.: B60R 25/00, G07C 9/00, E05B 65/20

(54) **HANDHABE**
HANDLE
COMMANDE

(30) Priorität: 20.02.2006 DE 102006008144
(43) Veröffentlichungstag der Anmeldung: 12.11.2008
(73) Patentinhaber: Huf Hülsbeck & Fürst GmbH & Co. KG, 42551 Velbert (DE)
(72) Erfinder: STEEGMANN, Bernd, 42579 Heiligenhaus (DE)
(74) Vertreter: Vogel, Andreas
(86) Internationale Anmeldenummer: PCT/EP2007/051504
(87) Internationale Veröffentlichungsnummer: WO 2007/096303

(56) Entgegenhaltungen:
- EP-A1- 1 168 678
- DE-A1- 10 163 778
- FR-A- 2 872 468
- US-A- 5 682 032

## Beschreibung

In der WO 2005/006261 A1 ist eine elektronische Zugangskontrollvorrichtung zu einem gesicherten Innenraum eines Kraftfahrzeuges beschrieben, die einen ID-Geber mit einer Sende- und Empfangseinrichtung, eine-für den Zugang einer Person zu öffnenden Tür mit einem Türschloss und eine in dem Innenraum angeordnete, mit einer Sende- und Empfangseinrichtung verbundene Steuereinheit aufweist, die im Falle einer beabsichtigten Türöffnung eine Kommunikation mit dem ID-Geber beginn und auf ein Wecksignal hin von dem ID-Geber gesendete Identifikationsdatensignale empfängt. Hierbei erfolgt eine Schlossentriegelung des Türschlosses durch die Steuereinheit, wenn die gesendeten Identifikationsdatensignale des ID-Gebers mit den in der Steuereinheit vorhandenen Identifikationsdaten übereinstimmen. Die Sende- und Empfangseinrichtung erhält die Identifikationsdatensignale kapazitiv der induktiv, wobei mindestens eines der Signale, nämlich das Wecksignal und/oder die Identifikationsdatensignale kapazitiv übertragbar sind. Es hat sich gezeigt, dass es bei der Detektion einer Annäherung einer Person öder bei der Berührung des Türgriffes sowie bei der kapazitiven Aussendung des Wecksignals zu Störungen kommen kann, Ferner weist die genannte Vorrichtung eine Vielzahl an Bauteilen auf, insbesondere aufgrund der induktiven Übertragung der Datensignale,: wodurch sich der Montageaufwand sowie der notwendig Bauraum erhöhen.

In der EP-A-1168678 wird eine Handhabe offenbart, die für ein schlüsselloses Zugang-und/oder Fahrberechtigungssystem ist. Bei diesem System sind viele Bauteile erforderlich, die räumlich voneinander getrennt und außerhalb der Handhabe angeordnet sind. Die Herstellung dieser Anlage ist aufwendig und ihr Aufbau kompliziert.

Der Erfindung liegt die Aufgabe zugrunde, eine Handhabe für ein schlüsselloses Zugang- und/oder Aahrberechtigungskontrollsystem sowie ein Verfahren hierfür zu schaffen, welches die genannten Nachteile vermeidet, insbesondere eine Handhabe und ein Verfahren bereit gestellt wird die eine zuverlässige Funktionsweise gewährleisten.

Zur Lösung dieser Aufgabe wird eine Handhabe mit den Merkmalen des Anspruches 1 vorgeschlagen. Vorteilhafte Ausführungsformen der erfindungsgemäßen Handhabe sind in den abhängigen Unteransprüchen aufgeführt. In der nachfolgenden Beschreibung wird der Begriff Türgriff allgemein für eine Handhabe für ein bewegliches Element verwendet, wobei das bewegliche Element beispielsweise ein Handschuhfach, eine Kofferraumtür, ein Tankdeckel oder eine Fahrzeugzeugtür sein kann.

Erfindungsgemäß ist vorgesehen, dass die Elektronikeinheit mindestens eine Kommunikationsfläche aufweist, die durch eine innerhalb des Gehäuses angeordnete Steuereinheit mittels eines Schaltelementes in mindestens zwei Betriebszustände schaltbar ist, wobei in einem ersten Betriebszustand die Kommunikationsfläche ein kapazitiver Näherungssensor und in einem zweiten Betriebszustand ein Sendeelement ist, von dem das Wecksignal über eine kapazitive Kopplung auf die Person übertragen wird. Nähert sich die Person, insbesondere dessen Hand dem Türgriff, der sich in dem ersten Betriebszustand befindet, detektiert der kapazitive Näherungssensor ab einem bestimmten Abstand die Person, welches der Steuereinheit mitgeteilt wird. Anschließend schaltet die Steuereinheit mittels des Schaltelementes die Elektronikeinheit in den zweiten Betriebszustand, in dem die Kommunikationsfläche anstelle eines kapazitiven Näherungssensors als kapazitives Sendeelement wirkt. Erfindungsgemäß erfolgt die Aussendung des kodierten Wecksignals durch kapazitive Kopplung unter Einbeziehung der Person, die den Zugang in den geschützten Bereich des Kraftfahrzeuges wünscht. Zur kapazitiven Signalübertragung des Wecksignals von der Kommunikationsfläche über die Person zum ID-Geber ist eine unmittelbare Berührung oder zumindest ein sehr kleiner Abstand zwischen der Person und dem als Türgriff ausgeführten beweglichen Elementes erforderlich. Nachdem die Kommunikationsfläche in ihrem ersten Betriebszustand die Annäherung der Person erkannt hat, befindet sich die Kommunikationsfläche nach ihrer Umschaltung in ihrem zweiten Betriebszustand. Berührt die Person, die den Zugang in das Kraftfahrzeug wünscht, den Türgriff, wird das Wecksignal von der Kommunikationsfläche über eine kapazitive Kopplung auf die Person und schließlich zum ID-Geber übertragen. Hierbei kann der ID-Geber sich in einem Kleidungsstück der Person oder sogar in einem Koffer oder dergleichen befinden, der von der Person getragen wird, ohne dass Störungen des Wecksignals auftreten. Besonders vorteilhaft ist, dass für den kapazitiven Näherungssensor und das kapazitive Sendeelement lediglich ein Bauteil notwendig ist, wodurch der erforderliche Bauraum gering gehalten werden kann. Um eine gute Funktionsweise zu gewährleisten, ist die schaltbare Kommunikationsfläche möglichst freiliegend zur zugewandten Außenfläche des Türgriffes, die während der kapazitiven Übertragung von der Person berührt wird. Das bedeutet, dass sich insbesondere keine elektronischen Bauteile zwischen der Außenfläche des Türgriffes und der Kommunikationsfläche befinden.

Vorteilhafterweise wird die Kommunikationsfläche als kapazitiver Näherungssensor mit einer elektrischen Spannung betrieben, die sich von der Spannung unterscheidet, die für das Sendeelement im zweiten Betriebszustand notwendig ist. Diese intelligente Schaltung der Kommunikationsfläche erfolgt durch die im Türgriff angeordnete Steuereinheit, die je nach Betriebszustand die Kommunikationsfläche derart elektrisch betreibt, dass zuverlässig eine Annäherung einer Person oder eine Berührung des Türgriffes sowie eine Aussendung des Wecksignals erfolgen kann, ohne durch Störgrößen in der Signalübertragung negativ beeinflusst zu werden. Hierbei liegt sowohl im ersten als auch im zweiten Betriebszustand an der Kommunikationsfläche ein entsprechendes elektrisches Wechselfeld an, wodurch kapazitiv eine Annäherung oder Berührung erkannt und Wecksignale ausgesendet werden können.

Bei dem Schaltelement, das die Kommunikationsfläche in den entsprechenden Zustand schaltet, kann es sich zum Beispiel um ein Relais oder IC handeln. Nachdem das Wecksignal kapazitiv zum ID-Geber weiter geleitet wurde, erfolgt vorteilhafterweise eine Überprüfung innerhalb des ID-Gebers. Der ID-Geber sendet auf das Wecksignal hin über seine Sendeeinrichtungen ein Antwortsignal in Form von Identifikationsdatensignale als codierte Nachricht an das Kraftfahrzeug zurück, die insbesondere durch kraftfahrzeugseitige Empfangseinrichtungen empfangen werden. Eine Schlossentriegelung des Türschlosses erfolgt durch eine Steuereinheit, wenn die gesendeten Identifikationsdaten des elektronischen Schlüssels mit in der Steuereinheit feststehenden Identifikationsdaten übereinstimmen. Bei der Steuereinheit kann es sich um eine außerhalb des Türgriffes angeordnete Steuereinheit handeln. Selbstverständlich kann die innerhalb des Türgriffes positionierte Steuereinheit, die für die Umschaltung der Kommunikationsfläche verantwortlich ist, zusätzlich für die Schlossentriegelung zum Einsatz kommen. Die Empfangseinrichtungen für den Empfang der Identifikationsdatensignale des ID-Gebers sind vorzugsweise am Kraftfahrzeug positioniert. Ebenfalls ist es denkbar, die Empfangseinrichtungen am Türgriff zu integrieren.

Erfindungsgemäß ist die Kommunikationsfläche innerhalb des Türgriffes angeordnet, wobei ein Abstand zwischen der Außenfläche des Türgriffes und der Kommunikationsfläche besteht. Vorzugsweise ist der Abstand geringer als 10 mm, mehr bevorzugt geringer als 5 mm und besonders bevorzugt geringer als 2 mm. Um eine zufrieden stellende Funktionsweise zu erhalten, kann die Kommunikationsfläche rechteckförmig oder quadratisch ausgeführt sein. Weitere geometrische Formen sind ebenfalls denkbar. Des Weiteren ist die als Elektrode wirkende Kommunikationsfläche vorzugsweise in ihrer flächigen Form dünn ausgebildet. Der Bereich zwischen Außenfläche des Türgriffes und der Kommunikationsfläche ist vorteilhafterweise isolierend ausgeführt.

In einer vorteilhaften Ausführungsform der Erfindung ist die Kommunikationsfläche, die vorteilhafterweise eine metallische Fläche ist, an der der Tür des Kraftfahrzeuges zugewandten Seite des Türgriffes angeordnet. Im Gegensatz zu der im Stand der Technik genannten induktiven Signalübertragung, bei der eine Vielzahl an induktiven Antennen, Sendeendstufen, Relais, Kabelbäume, Steckverbinder, etc. notwendig sind, reicht eine als kapazitive Sende-/Näherungssensor-Elektrode arbeitende Kommunikationsfläche aus. In einer möglichen Ausführungsform des Türgriffes weist die Elektronikeinheit eine Leiterplatte auf, an der die Kommunikationsfläche angeordnet ist. In diesen Fall ist die Kommunikationsfläche an der Leiterplatte integriert angeordnet, die starr oder flexibel, beispielsweise als Folie ausgebildet ist sein kann. Die Kommunikationsfläche kann hingegen eine Kupferfläche sein.

Eine weitere Alternative sieht vor, dass die Kommunikationsfläche als separates Bauteil innerhalb des Türgriffes angeordnet ist. Vorteilhafterweise weist das Gehäuse einen Hohlraum auf, in dem die Elektronikeinheit in einem nicht leitenden Material vergossen ist, wodurch der Türgriff seine geforderte Festigkeit erhält. Der Hohlraum ist mit einer Innenwandung ausgeführt, an der die Kommunikationsfläche anliegen kann. Während der Montage wird die Kommunikationsfläche über eine Leitung sowie zur Steuereinheit verbunden und anschließend mit dem nicht leitenden Material vergossen. Um eine zuverlässige Fixierung der Kommunikationsfläche an der Innenwandung des Gehäuses sicherzustellen, kann zwischen der an der Innenwandung anliegenden Kommunikationsfläche und der Leiterplatte mindestens ein Abstandselement angeordnet sein. Hierdurch wird unter anderem erreicht, dass während des Gießvorganges die Kommunikationsfläche zuverlässig an der Innenwandung des Hohlraumes verbleibt. Die Abstandselemente sind vorteilhafterweise aus Kunststoff ausgeführt, die vor dem Gießvorgang form-/oder kraftschlüssig mit der Kommunikationsfläche und der Leiterplatte verbunden sind. Alternativ kann es sich bei der Kommunikationsfläche um eine auf der Innenwandung des Hohlraumes beschichtete metallische Fläche handeln, die mit der Leiterplatte im elektrischen Kontakt steht.

Des Weiteren kann vorgesehen sein, dass eine weitere Kommunikationsfläche an der dem beweglichen Element abgewandten Seite des Türgriffes angeordnet ist, die für einen Verriegelungsvorgang des beweglichen Elementes vorgesehen ist. Wie für die beschriebene Zugangskontrolle zur Entriegelung des beweglichen Elementes kann die weitere Kommunikationsfläche für das Verriegeln des beweglichen Elementes eingesetzt werden. Diese weitere Kommunikationsfläche ist ebenfalls in mindestens zwei Betriebszustände durch die Steuereinheit schaltbar, wobei hier - um Wiederholungen zu vermeiden - auf die zuvor genannten Ausführungen, insbesondere zu Anspruch 1 verwiesen wird. Die genannte Kommunikationsfläche, die im ersten Betriebszustand als kapazitiver Näherungssensor geschaltet ist, erkennt ab einem bestimmten Abstand die Person, die das Fahrzeug verschließen will. Im Anschluss erfolgt eine Schaltung der Elektronikeinheit von dem ersten Betriebszustand in den zweiten Betriebszustand, in dem die Kommunikationsfläche als kapazitives Sensorelement wirkt, von dem das Wecksignal über die kapazitive Kopplung auf die Person sowie auf den ID-Geber übertragen wird. Der von der Person getragene ID-Geber wird durch das kapazitive Signal geweckt und sendet ein Antwortsignal bzw. ein Identifikationsdatensignal in Richtung Kraftfahrzeug. Fahrzeugseitig erfolgt eine Überprüfung der Identifikationsdaten. Bei einer positiven Feststellung einer Identifikation wird eine Verriegelung der Fahrzeugtüren veranlasst.

In einer weiteren möglichen Ausführungsform des Türgriffes kann an der Außenfläche des Gehäuses eine metallische Blende angeordnet sein, die mit der innerhalb des Gehäuses angeordneten Kommunikationsfläche kapazitiv gekoppelt ist. Bei der metallischen Blende kann es sich beispielsweise um eine Chromblende handeln, die das Design des Türgriffes aufwertet. Da die metallische Blende mit der innerhalb des Gehäuses angeordneten Kommunikationsfläche kapazitiv gekoppelt ist, wirkt die metallische Blende je nach geschaltetem Betriebszustand gleichzeitig als Näherungssensor oder als Sendeelement. Hierbei besteht die Möglichkeit, die metallische Blende direkt über eine Schutzschaltung kapazitiv anzukoppeln oder über eine Koppelelektrode isoliert kapazitiv zu koppeln.

Darüber hinaus wird die Aufgabe durch ein Verfahren für eine schlüssellose Zugangskontrolle zu einem Kraftfahrzeug mit einem Türgriff gelöst, der ein aus Kunststoff ausgeführtes Gehäuse umfasst, in dem eine Elektronikeinheit angeordnet ist, die eine Annäherung einer Person und/oder eine Berührung des Türgriffes erfasst und ein codiertes Wecksignal aussendet, das kapazitiv auf die Person übertragen und einem ID-Geber weitergeleitet wird. Hierbei ist eine am Türgriff angeordnete Kommunikationsfläche vorhanden, die von einer innerhalb des Gehäuses angeordneten Steuereinheit über ein Schaltelement in mindestens zwei Betriebszustände schaltbar ist, wobei in einem ersten Betriebszustand die Kommunikationsfläche als kapazitiver Näherungssensor arbeitet, der eine Annäherung kapazitiv erfasst, welches der Steuereinheit mitgeteilt wird, die anschließend die Kommunikationsfläche in den zweiten Betriebszustand schaltet, in dem das Wecksignal über eine kapazitive Kopplung auf die Person und den ID-Geber übertragen wird. Die Elektronikeinheit kann so eingestellt sein, dass die sich nähernde Person, insbesondere Hand vom kapazitiven Näherungssensor vorzugsweise erst in einem Abstand von ca. 5 bis 10 cm erkannt wird. Anschließend erfolgt eine entsprechende Umschaltung der Kommunikationsfläche auf ihren zweiten Betriebszustand. Vorteilhafterweise wird die Kommunikationsfläche derart betrieben, dass eine Übertragung des Wecksignals nur bei einer Berührung des Türgriffes erfolgt. In diesem Fall kann die als Sendeelement arbeitende Kommunikationsfläche mit einer entsprechenden reduzierten Sendespannung betrieben werden, wodurch eine aus dem Stand der Technik bekannte nachteilige Funkstreckenverlängerung nicht möglich ist. Vorteilhafte Ausgestaltungen des erfindungsgemäßen Verfahrens sind in den Unteransprüchen aufgeführt.

In einer weiteren Möglichkeit der Erfindung kann das Wecksignal nur einmal oder auch mehrfach kapazitiv auf die Person und anschließend auf den ID-Geber übertragen werden. Da die Bewegungsgeschwindigkeit der Hand der Person sehr unterschiedlich sein kann, kann es sinnvoll sein, das Wecksignal mehrfach, zum Beispiel 10 mal zu senden. Die Elektronikeinheit kann derart eingestellt sein, dass die erste kapazitive Datenübertragung des Wecksignals auch unmittelbar vor der Berührung "überspringen" kann, das bedeutet es kann bereits vor einer Berührung eine kapazitive Übertragung erfolgen.

Zweckmäßiger Weise wird die Kommunikationsfläche kurzzeitig in den zweiten Betriebszustand geschaltet, vorzugsweise für weniger als 3 Sekunden, mehr bevorzugt für weniger als 2 Sekunden und besonders bevorzugt für weniger als 1 Sekunde. Nach dem zweiten Betriebszustand wird vorteilhafterweise die Kommunikationsfläche zurück in den ersten Betriebszustand geschaltet.

In einer möglichen Ausführungsform der Erfindung kann die Kommunikationsfläche in einen dritten Betriebszustand für den Empfang eines kapazitiven Antwortsignals geschaltet werden, welches vom ID-Geber ausgesendet wird und über die den Türgriff berührenden Person auf die Kommunikationsfläche des Türgriffes übertragen wird.

Da die Annäherungsgeschwindigkeit der Person, insbesondere der Hand zum Türgriff in der Regel variabel ist, wird zweckmäßigerweise durch die Annäherung der Person die Steuereinheit aktiviert und die kapazitive Übertragung zeitlich mit dem Berührungszeitpunkt synchronisiert. Hierbei kann eine Umschaltung der Kommunikationsfläche sofort erfolgen, wobei die Aussendung des Wecksignals variabel verzögert wird. Dazu kann der Näherungssensor den Berührungssensor exakt erfassen und dann sofort das Wecksignal aussenden. Dadurch werden unvollständige empfangene Wecksignale vermieden und die Gesamtreaktionszeit verkürzt. Auch die Abhörsicherheit wird dadurch erhöht, da das Signal stets direkt über den Körper zum ID-Geber geleitet wird. Der Näherungssensor kann selbstabgleichend ausgeführt sein, der sich auf Umwelteinflüsse einstellt und somit ein konstantes Verhalten aufweist.

Weitere Vorteile, Merkmale und Einzelheiten der Erfindung ergeben sich aus den Unteransprüchen, der nachfolgenden Beschreibung, in der unter Bezugnahme auf die Zeichnungen mehrere Ausführungsbeispiele der Erfindung im Einzelnen beschrieben sind. Dabei können die in den Ansprüchen und der Beschreibung erwähnten Merkmale jeweils einzeln für sich oder in beliebiger Kombination erfindungswesentlich sein. Es zeigen:
- Figur 1: eine rein schematische Darstellung eines erfindungsgemäßen Türgriff eines Kraftfahrzeuges mit einer Kommunikationsfläche,
- Figur 2: die Kommunikationsfläche gemäß Figur 1,3,4 und 5, die in zwei Betriebszustände schaltbar ist,
- Figur 3: eine Fixierungsmöglichkeit der Kommunikationsfläche mittels eines Abstandselementes,
- Figur 4: eine Alternative des efindungsgemäßen Türgriffes mit einer Kommunikationsfläche und
- Figur 5: eine weitere Ausführungsform des Türgriffes mit einer Korrimunikationsfläche.

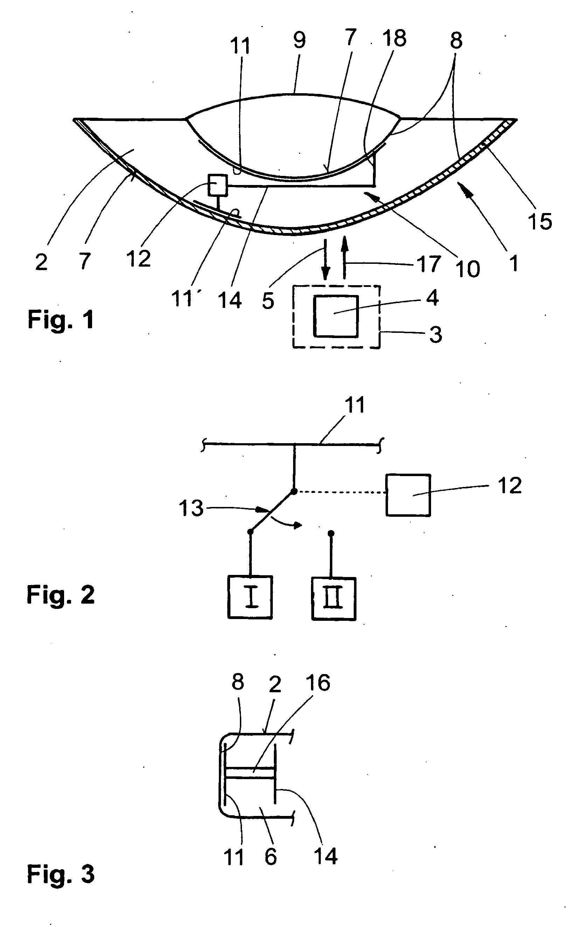

Figur 1 zeigt einen Türgriff 1 eines Kraftfahrzeuges für ein schlüsselloses Zugangs- und Fahrberechtigungskontrollsystem. Der Türgriff 1 weist ein Gehäuse 2 auf, das ein Spritzgussteil aus Kunststoff ist. Innerhalb des Gehäuses 2 ist eine Elektronikeinheit 10 angeordnet, die eine Annäherung einer Person 3 bzw. eine Berührung des Türgriffes 1 durch die Person 3 erfasst und ein codiertes Wecksignal 5 aussendet, das kapazitiv auf die Person 3 übertragen und einem ID-Geber 4 weitergeleitet wird, den die Person 3 mit sich trägt.

Die Elektronikeinheit 10 weist eine Kommunikationsfläche 11 auf, die an der der Tür 9 des Kraftfahrzeuges zugewandten Seite des Türgriffes 1 angeordnet ist. Eine weitere Kommunikationsfläche 11' befindet sich an der der Tür 9 abgewandten Seite des Türgriffes 1. Gemäß Figur 1 weisen die Kommunikationsflächen 11, 11' einen Abstand zur Außenfläche 7 des Türgriffes 1 auf, der ungefähr 2 mm beträgt. Hinsichtlich aller Ausführungsbeispiele dient die Kommunikationsfläche 11 für den Öffnungsvorgang und die Kommunikationsfläche 11' für den Schließvorgang.

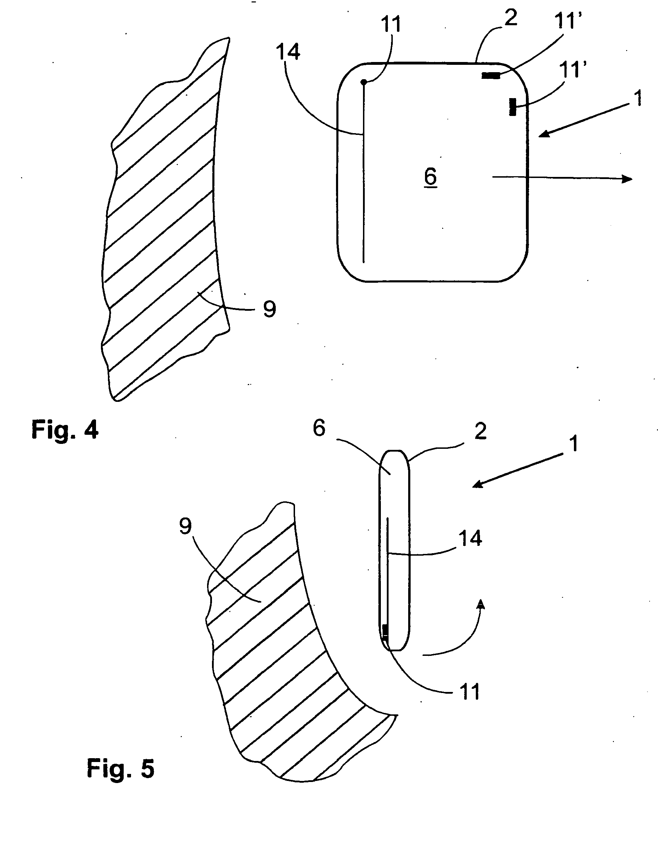

In Figur 4 ist eine weitere Ausführungsform der Erfindung dargestellt, bei der der Türgriff 1 als Ziehgriff ausgeführt ist. Hierbei weist der Türgriff 1 ein Gehäuse 2 auf, in dessen Hohlraum 6 die Elektronikeinheit mit der Leiterplatte 14 angeordnet ist, die der Tür 9 zugewandt ist. Bei dieser Ausführungsform ist die Kommunikationsfläche 11 im oberen Bereich des Türgriffes 1 unmittelbar an der Leiterplatte 14 positioniert, wobei die Kommunikationsfläche 11 eine schmale streifenförmige Form aufweist und sich entlang der Leiterplatte 14 erstreckt. In Figur 4 sind zwei Alternativen für die Kommunikationsfläche 11' aufgezeigt, die an der der Tür 9 abgewandten Seite des Türgriffes 1 angeordnet und mit der Leiterplatte 14 verbunden sind, welches nicht explizit dargestellt ist. In einer möglichen Ausführungsform befindet sich die Kommunikationsfläche 11' an der Gehäuseoberseite oder in einer weiteren Alternative an der Gehäuseseitenwand, die der Tür 9 abgewandt ist.

In einer weiteren Alternative der Erfindung ist der Türgriff 1 als Klappgriff vorgesehen, welches exemplarisch in Figur 5 gezeigt ist. Die Elektronikeinheit mit der Leiterplatte 14 befindet sich ebenfalls innerhalb des Gehäuses 2, wobei die Kommunikationsfläche 11 im unteren Bereich des Türgriffes 1 angeordnet ist.

Die Kommunikationsflächen 11, 11' sind mit einer Steuereinheit 12 verbunden, die die Kommunikationsflächen 11, 11' in zwei Betriebszustände I, II schalten kann, welches in Figur 2 rein schematisch dargestellt ist. Die Steuereinheit 12 befindet sich auf einer Leiterplatte 14. Die Kommunikationsfläche 11 ist über eine Verbindungsleitung 18 mit der Leiterplatte 14 verbunden, wohin gegen die Kommunikationsfläche 11' direkt mit der Steuereinheit 12 verbunden ist. Selbstverständlich ist eine Verbindung der Kommunikationsfläche 11' mit der Steuereinheit 12 über eine Verbindungsleitung zur Leiterplatte 14 ebenfalls denkbar. Der Türgriff 1 weist einen Hohlraum auf, in dem die genannten elektronischen Bauteile positioniert sind. Gemäß Figur 1 liegen beide Kommunikationsflächen 11, 11' an der Innenwandung 8 des Gehäuses 2 an. Nachdem die elektronischen Bauteile im Hohlraum des Türgriffes 1 eingesetzt wurden, wird der Hohlraum mit einem nicht leitenden Kunststoff vergossen. Um während des Gießprozesses die Kommunikationsflächen 11, 11' in ihrer Position zuverlässig zu halten, können Abstandselemente 16 zur Fixierung verwendet. Dieses ist exemplarisch in Figur 3 dargestellt, bei der die Kommunikationsfläche 11 mit einem Abstandselement 16 mit der Leiterplatte 14 verbunden ist. Die Kommunikationsfläche 11 liegt an der Innenwandung 8 des Gehäuses 2 an. Der Hohlraum 6 des Gehäuses 2 ist durch die nicht explizit dargestellte Vergussmasse aus Kunststoff ausgefüllt.

Gemäß Figur 2 kann die Steuereinheit 12 mittels eines Schaltelementes 13 die Kommunikationsfläche 11 in einen ersten Betriebszustand I schalten, bei dem die Kommunikationsfläche 11 als kapazitiver Näherungssensor wirkt. Im zweiten Betriebszustand II arbeitet die Kommunikationsfläche 11 als kapazitives Sendeelement. Wie in Figur 1 zu erkennen ist, ist eine metallische Blende 15 aus Chrom an der Außenfläche 7 angeordnet. Die Blende 15 ist mit der Kommunikationsfläche 11' kapazitiv gekoppelt.

Das Verfahren, mit dem die Person 3 der authentifizierte Zugang zu einem geschlossenen Bereich des Kraftfahrzeuges ermöglicht wird, läuft nun wie folgt ab: Die Person 3 nähert sich dem Türgriff 1. Hierbei befindet sich die Elektronikeinheit 10 im ersten Betriebszustand I. Ab einem bestimmten Abstand wird eine Annäherung über die als kapazitiven Näherungssensor arbeitenden Kommunikationsfläche 11 detektiert. Anschließend veranlasst die Steuereinheit 12 eine Umschaltung der Kommunikationsfläche 11 in den zweiten Betriebszustand **II,** in dem die Kommunikationsfläche 11 als kapazitives Sendeelement wirkt. Die Elektronik des Türgriffes 1 ist derart eingestellt, dass erst bei einer Berührung des Türgriffes 1 eine kapazitive Übertragung des Wecksignals 5 auf die Person 3 und anschließend auf den ID-Geber 4 erfolgt. Im Anschluss daran erfolgt eine Aussendung eines Identifizierungsdatensignals vom ID-Geber 4 zum Kraftfahrzeug zurück. Dieses Identifizierungsdatensignal 17 wird über nicht dargestellte Antennen empfangen und kraftfahrzeugseitig überprüft, inwieweit die gesendeten Identifizierungsdaten mit kraftfahrzeugseitig gespeicherten Identifizierungsdaten übereinstimmen. Bei einer positiven Übereinstimmung erfolgt eine Entriegelung der Fahrzeugtür 9. Im vorliegenden Ausführungsbeispiel ist das Signal 17 ein HF-Signal.

Ein Schließvorgang der Fahrzeugtür 9 wird in der Weise realisiert, dass die Person 3 sich dem Türgriff-1 im Bereich der Kommunikationsfläche 11' nähert. Hierbei befindet sich die Kommunikationsfläche 11' zunächst in dem ersten Betriebszustand I, arbeitet also als kapazitiver Näherungssensor. Wie bei der Kommunikationsfläche 11 erfolgt eine Umschaltung in den zweiten Betriebszustand II, so dass bei einer Berührung des Türgriffes 1 im Bereich der Kommunikationsfläche 11' kapazitiv das Wecksignal 5 auf den ID-Geber 4 übertragen wird. Anschließend sendet der ID-Geber 4 das entsprechende Identifikationsdatensignal 17 zurück, welches fahrzeugseitig mit gespeicherten Referenzidentifikationsdaten überprüft wird. Bei einer positiven Übereinstimmung erfolgt eine Verriegelung der Fahrzeugtür 9.

Der ID-Geber 4 ist im dargestellten Ausführungsbeispiel derart eingestellt, dass ein Identifizierungsdatensignal 17 erst dann ausgesendet wird, wenn das richtige Wecksignal 5 den ID-Geber 4 erreicht hat. Das bedeutet, dass das Wecksignal 5 innerhalb des ID-Gebers 4 ebenfalls überprüft wird. Um eine zuverlässige Funktionsweise zu gewährleisten, wird das Wecksignal 5 mehrfach kapazitiv auf den ID-Geber 4 übertragen. Die Kommunikationsflächen 11, 11' werden durch die Steuereinheit 12 nur kurzzeitig im zweiten Betriebszustand II gehalten. Anschließend erfolgt eine Schaltung der Kommunikationsflächen 11, 11' in den ersten Betriebszustand **I.**

Falls etwaige Signalstörungen auftreten sollten, ist ein Notzugang über einen mechanischen Schlüssel, der am ID-Geber 4 angeordnet ist, ebenfalls möglich.

### Bezugszeichenliste

- 1: Handhabe, Türgriff
- 2: Gehäuse
- 3: Person
- 4: ID-Geber
- 5: Wecksignal
- 6: Hohlraum
- 7: Außenfläche
- 8: Innenwandung
- 9: bewegliches Element, Tür
- 10: Elektronikeinheit
- 11: Kommunikationsfläche
- 12: Steuereinheit
- 13: Schaltelement
- 14: Leiterplatte
- 15: Blende
- 16: Abstandselement
- 17: Antwortsignal
- 18: Verbindungsleitung

## Patentansprüche

1. Handhabe (1), insbesondere Türgriff eines Kraftfahrzeuges, für ein schlüsselloses Zugangs- und/oder Fahrberechtigungskontrollsystem, mit einem aus Kunststoff ausgeführten Gehäuse (2), in dem eine Elektronikeinheit (10) angeordnet ist, die eine Annäherung einer Person (3) und/oder eine Berührung der Handhabe (1) erfasst und ein codiertes Wecksignal (5) aussendet, das kapazitiv auf die Person (3) übertragen und einem ID-Geber (4) weitergeleitet wird, wobei die Elektronikeinheit (10) mindestens eine Kommunikationsfläche (11, 11') aufweist, die durch eine innerhalb des Gehäuses (2) angeordnete Steuereinheit (12) mittels eines Schaltelementes (13) in mindestens zwei Betriebszustände schaltbar ist, wobei in einem ersten Betriebszustand die Kommunikationsfläche (11, 11') ein kapazitiver Näherungssensor und in einem zweiten Betriebszustand ein Sendeelement ist, von dem das Wecksignal (5) über eine kapazitive Kopplung auf die Person (3) übertragen wird.

2. Handhabe (1) nach Anspruch 1,
**dadurch gekennzeichnet,**
**dass** die Kommunikationsfläche (11, 11') innerhalb der Handhabe (1) angeordnet ist, wobei ein Abstand zwischen der Außenfläche (7) der Handhabe (1) und der Kommunikationsfläche (11,11') besteht.

3. Handhabe (1) nach Anspruch 1 oder 2,
**dadurch gekennzeichnet,**
**dass** die Kommunikationsfläche (11) an einer einem beweglichen Element (9), insbesondere einer Tür (9) des Kraftfahrzeuges zugewandten Seite der Handhabe (1) angeordnet ist.

4. Handhabe (1) nach Anspruch 3,
**dadurch gekennzeichnet,**
**dass** die Kommunikationsfläche (11) im oberen und/oder unteren Bereich der Handhabe (1) positioniert ist.

5. Handhabe (1) nach einem der vorhergehenden Ansprüche,
**dadurch gekennzeichnet,**
**dass** die Kommunikationsfläche (11, 11') eine metallische Fläche ist, die starr oder flexibel ausgeführt ist.

6. Handhabe (1) nach einem der vorhergehenden Ansprüche,
**dadurch gekennzeichnet,**
**dass** die Elektronikeinheit (10) eine Leiterplatte (14) aufweist, an der die Kommunikationsfläche (11, 11') angeordnet ist.

7. Handhabe (1) nach einem der vorhergehenden Ansprüche,
**dadurch gekennzeichnet,**
**dass** das Gehäuse (2) einen Hohlraum (6) aufweist, in dem die Elektronikeinheit (10) in einem nicht leitenden Material vergossen ist.

8. Handhabe (1) nach Anspruch 7,
**dadurch gekennzeichnet,**
**dass** der Hohlraum (6) eine Innenwandung (8) aufweist, an der die Kommunikationsfläche (11, 11') anliegt.

9. Handhabe (1) nach Anspruch 8,
**dadurch gekennzeichnet,**
**dass** die Form der Kommunikationsfläche (11, 11') der Kontur der Innenwandung (8) angepasst ist.

10. Handhabe (1) nach einem der vorhergehenden Ansprüche,
**dadurch gekennzeichnet,**
**dass** die Kommunikationsfläche (11, 11') rechteckförmig, quadratisch oder streifenförmig ausgeführt ist.

11. Handhabe (1) nach einem der vorhergehenden Ansprüche,
**dadurch gekennzeichnet,**
**dass** zwischen der an der Innenwandung (8) anliegenden Kommunikationsfläche (11, 11') und der Leiterplatte (14) mindestens ein Abstandselement (16) angeordnet ist.

12. Handhabe (1) nach einem der vorhergehenden Ansprüche,
**dadurch gekennzeichnet,**
**dass** eine weitere Kommunikationsfläche (11') an der dem beweglichen Element (9) abgewandten Seite der Handhabe (1) angeordnet ist, die für einen Verriegelungsvorgang des beweglichen Elementes (9) vorgesehen ist.

13. Handhabe (1) nach einem der vorhergehenden Ansprüche,
**dadurch gekennzeichnet,**
**dass** eine metallische Blende (15) an der Außenfläche (7) angeordnet ist, die mit der innerhalb des Gehäuses (2) angeordneten Kommunikationsfläche (11') kapazitiv gekoppelt ist.

14. Verfahren für eine schlüssellose Zugangskontrolle zu einem Kraftfahrzeug mit
einer Handhabe (1), insbesondere einem Türgriff (1), die ein aus Kunststoff ausgeführtes Gehäuse (2) umfasst, In dem eine Elektronikeinheit (10) angeordnet
ist, die eine Annäherung einer Person (3) und/oder eine Berührung der Handhabe (1) erfasst und ein codiertes Wecksignal (5) aussendet, das kapazitiv auf die Person (3) übertragen und einem ID-Geber (4) weitergeleitet wird, wobei eine an der Handhabe (1) angeordnete Kommunikationsfläche (11, 11') vorhanden Ist, die von einer innerhalb des Gehäuses (2) angeordneten Steuereinhelt (12) über ein Schaltelement (13) In mindestens zwei Betriebszustände schaltbar Ist, wobei In einem ersten Betriebszustand die
Kommunlkatlonsnäche (11, 11') als kapazitiver Näherungssensor arbeitet, der eine Annäherung kapazitiv erfasst, welches der Steuereinheit (12) mitgeteilt wird, die anschließend die Kommunikationsfläche (11, 11') In den zweiten Betriebszustand schaltet, in dem das Wecksignal (5) über eine kapazitive Kopplung auf die Person (3) und den ID-Geber (4) übertragen wird.

15. Verfahren nach Anspruch 14,
**dadurch gekennzeichnet,**
**dass** die Kommunikationsfläche (11, 11') derart betrieben wird, dass eine Übertragung des Wecksignals (5) nur bei einer Berührung der Handhabe (1) erfolgt.

16. Verfahren nach einem der vorhergehenden Ansprüche,
**dadurch gekennzeichnet,**
**dass** das Wecksignal (5) einmal oder mehrfach kapazitiv übertragen wird.

17. Verfahren nach einem der vorhergehenden Ansprüche,
**dadurch gekennzeichnet,**
**dass** die Kommunikationsfläche (11, 11') kurzzeitig in den zweiten Betriebszustand geschaltet wird, vorzugsweise für weniger als 3 Sekunden, mehr bevorzugt für weniger als 2 Sekunden und besonders bevorzugt für weniger als 1 Sekunde.

18. Verfahren nach einem der vorhergehenden Ansprüche,
**dadurch gekennzeichnet,**
**dass** nach dem zweiten Betriebszustand die Kommunikationsfläche (11, 11') zurück in den ersten Betriebszustand geschaltet wird.

19. Verfahren nach einem der vorhergehenden Ansprüche,
**dadurch gekennzeichnet,**
**dass** die Kommunikationsfläche (11, 11') in einen dritten Betriebszustand für den Empfang eines kapazitiven Antwortsignals (17) geschaltet wird, welches vom ID-Geber (4) ausgesendet wird und über die die Handhabe (1) berührende Person (3) auf die Kommunikationsfläche (11, 11') übertragen wird.

20. Verfahren nach einem der vorhergehenden Ansprüche,
**dadurch gekennzeichnet,**
**dass** durch die Annäherung der Person die Steuereinheit (12) aktiviert wird und die kapazitive Übertragung zeitlich mit dem Berührungszeitpunkt synchronisiert wird.

21. Verfahren nach einem der vorhergehenden Ansprüche mit einer Handhabe (1) nach einem der Ansprüche 1 bis 13.

## Claims

1. A handle (1), in particular a door handle of a motor vehicle, for a keyless access and/or drive authorization control system, with a casing (2) which is produced from plastics material and in which an electronic unit (10) is arranged which detects the approach of a person (3) and/or the touching of the handle (1) and which emits an encoded wake-up signal (5) which is transmitted capacitively to the person (3) and forwarded to an ID transmitter (4), wherein the electronic unit (10) has at least one communication face (11, 11') which is capable of being switched into at least two operating states by means of a switching element (13) by a control unit (12) arranged inside the casing (2), wherein in a first operating state the communication face (11, 11') is a capacitive proximity sensor, and in a second operating state it is a transmitter element by which the wake-up signal (5) is transmitted to the person (3) by way of a capacitive coupling.

2. A handle (1) according to Claim 1, **characterized in that** the communication face (11, 11') is arranged inside the handle (1), wherein a distance is present between the outer face (7) of the handle (1) and the communication face (11, 11').

3. A handle (1) according to Claim 1 or 2, **characterized in that** the communication face (11) is arranged on a side of the handle (1) facing a movable element (9), in particular a door (9) of the motor vehicle.

4. A handle (1) according to Claim 3, **characterized in that** the communication face (11) is positioned in the upper and/or lower region of the handle (1).

5. A handle (1) according to any one of the preceding Claims, **characterized in that** the communication face (11, 11') is a metallic face which is made rigid or flexible.

6. A handle (1) according to any one of the preceding Claims, **characterized in that** the electronic unit (10) has a printed circuit board (14) on which the communication face (11, 11') is arranged.

7. A handle (1) according to any one of the preceding Claims, **characterized in that** the casing (2) has a cavity (6) in which the electronic unit (10) is cast in a non-conductive material.

8. A handle (1) according to Claim 7, **characterized in that** the cavity (6) has an inner wall (8) against which the communication face (11, 11') rests.

9. A handle (1) according to Claim 8, **characterized in that** the shape of the communication face (11, 11') is adapted to the contour of the inner wall (8).

10. A handle (1) according to any one of the preceding Claims, **characterized in that** the communication face (11, 11') is made rectangular, square or strip-shaped.

11. A handle (1) according to any one of the preceding Claims, **characterized in that** at least one spacer element (16) is arranged between the communication face (11, 11') resting against the inner wall (8) and the printed circuit board (14).

12. A handle (1) according to any one of the preceding Claims, **characterized in that** a further communication face (11') is arranged on the side of the handle (1) which faces away from the movable element (9) and which is provided for a locking procedure of the movable element (9).

13. A handle (1) according to any one of the preceding Claims, **characterized in that** a mechanical screen (15) is arranged on the outer face (7), which is coupled capacitively to the communication face (11') arranged inside the casing (2).

14. A method of keyless access control to a motor vehicle with a handle (1), in particular a door handle (1), which comprises a casing (2) which is produced from plastics material and in which an electronic unit (10) is arranged which detects the approach of a person (3) and/or the touching of the handle (1) and which emits an encoded wake-up signal (5) which is transmitted capacitively to the person (3) and forwarded to an ID transmitter (4), wherein a communication face (11, 11') is provided which is arranged on the handle (1) and which is capable of being switched into at least two operating states by way of a switching element (13) by a control unit (12) arranged inside the casing (2), wherein in a first operating state the communication face (11, 11') operates as a capacitive proximity sensor which detects an approach capacitively, which is reported to the control unit (12) which then switches the communication face (11, 11') to the second operating state in which the wake-up signal (5) is transmitted to the person (3) and the ID transmitter (4) by way of a capacitive coupling.

15. A method according to Claim 14, **characterized in that** the communication face (11, 11') is operated in such a way that a transmission of the wake-up signal (5) takes place only when the handle (1) is touched.

16. A method according to one of the preceding Claims, **characterized in that** the wake-up signal (5) is transmitted capacitively once or a multiplicity of times.

17. A method according to any one of the preceding Claims, **characterized in that** the communication face (11, 11') is switched briefly to the second operating state, preferably for less than 3 seconds, more preferably for less than 2 seconds and in a particularly preferred manner for less than 1 second.

18. A method according to any one of the preceding Claims, **characterized in that** after the second operating state the communication face (11, 11') is switched back to the first operating state.

19. A method according to any one of the preceding Claims, **characterized in that** the communication face (11, 11') is switched to a third operating state in order to receive a capacitive answer signal (17) which is emitted by the ID transmitter (4) and which is transmitted to the communication face (11, 11') by way of the person (3) touching the handle (1).

20. A method according to any one of the preceding Claims, **characterized in that** the control unit (12) is activated by the approach of the person and the capacitive transmission is synchronized in terms of time with the moment of touching.

21. A method according to any one of the preceding Claims with a handle (1) according to any one of Claims 1 to 13.

## Revendications

1. Poignée (1), en particulier poignée de porte d'un véhicule automobile, pour un système de contrôle d'accès et/ou d'autorisation de conduite sans clé, avec un boîtier (2) réalisé en matière plastique dans lequel est disposée une unité électronique (10) qui détecte une approche d'une personne (3) et/ou un contact avec la poignée (1) et émet un signal de réveil codé (5) qui est transmis par voie capacitive à la personne (3) et retransmis à un générateur d'ID (4), l'unité électronique (10) présentant au moins une surface de communication (11, 11') qui peut être mise dans au moins deux états de fonctionnement par une unité de commande (12) disposée à l'intérieur du boîtier (2) au moyen d'un élément de commutation (13), la surface de communication (11, 11') étant, dans un premier état de fonctionnement, un détecteur de proximité capacitif et, dans un deuxième état de fonctionnement, un élément d'émission par lequel le signal de réveil (5) est transmis à la personne (3) par un couplage capacitif.

2. Poignée (1) selon la revendication 1,
**caractérisée en ce**
**que** la surface de communication (11, 11') est disposée à l'intérieur de la poignée (1), une distance existant entre la surface extérieure (7) de la poignée (1) et la surface de communication (11, 11').

3. Poignée (1) selon la revendication 1 ou 2,
**caractérisée en ce**
**que** la surface de communication (11) est disposée d'un côté de la poignée (1) tourné vers un élément mobile (9), en particulier une porte (9) du véhicule automobile.

4. Poignée (1) selon la revendication 3,
**caractérisée en ce**
**que** la surface de communication (11) est positionnée dans la zone supérieure et/ou inférieure de la poignée (1).

5. Poignée (1) selon une des revendications précédentes,
**caractérisée en ce**
**que** la surface de communication (11, 11') est une surface métallique qui est de réalisation rigide ou souple.

6. Poignée (1) selon une des revendications précédentes,
**caractérisée en ce**
**que** l'unité électronique (10) présente une carte de circuits imprimés (14) sur laquelle la surface de communication (11, 11') est disposée.

7. Poignée (1) selon une des revendications précédentes,
**caractérisée en ce**
**que** le boîtier (2) présente une cavité (6) dans laquelle l'unité électronique (10) est scellée dans un matériau non conducteur.

8. Poignée (1) selon la revendication 7,
**caractérisée en ce**
**que** la cavité (6) présente une paroi intérieure (8) contre laquelle la surface de communication (11, 11') est appliquée.

9. Poignée (1) selon la revendication 8,
**caractérisée en ce**
**que** la forme de la surface de communication (11, 11') est adaptée au contour de la paroi intérieure (8).

10. Poignée (1) selon une des revendications précédentes,
**caractérisée en ce**
**que** la surface de communication (11, 11') est réalisée en forme de rectangle, de carré ou de bande.

11. Poignée (1) selon une des revendications précédentes,
**caractérisée en ce**
**qu'**au moins un élément d'écartement (16) est disposé entre la surface de communication (11, 11') appliquée contre la paroi intérieure (8) et la carte de circuits imprimés (14).

12. Poignée (1) selon une des revendications précédentes,
**caractérisée en ce**
**qu'**une autre surface de communication (11') est disposée du côté de la poignée (1) éloigné de l'élément mobile (9), laquelle est prévue pour un processus de verrouillage de l'élément mobile (9).

13. Poignée (1) selon une des revendications précédentes,
**caractérisée en ce**
**qu'**un écran métallique (15) est disposé sur la surface extérieure (7), lequel est couplé par voie capacitive à la surface de communication (11') disposée à l'intérieur du boîtier (2).

14. Procédé pour un contrôle d'accès sans clé à un véhicule automobile comportant une poignée (1), en particulier une poignée de porte (1), qui comprend un boîtier (2) réalisé en matière plastique dans lequel est disposée une unité électronique (10) qui détecte une approche d'une personne (3) et/ou un contact avec la poignée (1) et émet un signal de réveil codé (5) qui est transmis par voie capacitive à la personne (3) et retransmis à un générateur d'ID (4), une surface de communication (11, 11') disposée sur la poignée (1) étant présente, qui peut être mise dans au moins deux états de fonctionnement par une unité de commande (12) disposée à l'intérieur du boîtier (2) au moyen d'un élément de commutation (13), la surface de communication (11, 11') fonctionnant, dans un premier état de fonctionnement, comme détecteur de proximité capacitif qui détecte une approche par voie capacitive et la communique à l'unité de commande (12) qui met ensuite la surface de communication (11, 11') dans le deuxième état de fonctionnement dans lequel le signal de réveil (5) est transmis à la personne (3) par un couplage capacitif et au générateur d'ID (4).

15. Procédé selon la revendication 14,
**caractérisé en ce**
**que** la surface de communication (11, 11') fonctionne de telle façon qu'une transmission du signal de réveil (5) n'a lieu qu'en cas de contact avec la poignée (1).

16. Procédé selon une des revendications précédentes,
**caractérisé en ce**
**que** le signal de réveil (5) est transmis une fois ou plusieurs fois par voie capacitive.

17. Procédé selon une des revendications précédentes,
**caractérisé en ce**
**que** la surface de communication (11, 11') est momentanément mise dans le deuxième état de fonctionnement, de préférence pendant moins de 3 secondes, plus préférentiellement pendant moins de 2 secondes et particulièrement préférentiellement pendant moins de 1 seconde.

18. Procédé selon une des revendications précédentes,
**caractérisé en ce**
**qu'**après le deuxième état de fonctionnement, la surface de communication (11, 11') est remise dans le premier état de fonctionnement.

19. Procédé selon une des revendications précédentes,
**caractérisé en ce**
**que** la surface de communication (11, 11') est mise dans un troisième état de fonctionnement pour la réception d'un signal de réponse capacitif (17) qui est émis par le générateur d'ID (4) et transmis à la surface de communication (11, 11') par la personne (3) qui touche la poignée (1).

20. Procédé selon une des revendications précédentes,
**caractérisé en ce**
**que** l'unité de commande (12) est activée par l'approche de la personne et la transmission capacitive est synchronisée temporellement avec l'instant de contact.

21. Procédé selon une des revendications précédentes avec une poignée (1) selon une des revendications 1 à 13.
